# EUROPÄISCHE PATENTANMELDUNG

(11) **EP 0 617 468 A1**
(43) Veröffentlichungstag der Anmeldung: **28.09.1994**
(21) Anmeldenummer: 94103191.6
(22) Anmeldetag: 03.03.1994
(51) Int. Cl.: H01L 29/784, H01L 21/336

(54) **Kurzkanal-MOS-Transistor und Verfahren zu dessen Herstellung**

(30) Priorität: 22.03.1993 DE 4309182
(71) Anmelder: SIEMENS AKTIENGESELLSCHAFT, D-80333 München (DE)
(72) Erfinder: Klose, Helmut, Dr., D-81929 München (DE); Neppl, Franz, Dr., D-85521 Ottobrunn (DE)

(57) **Zusammenfassung**

Ein Kurzkanal-MOS-Transistor umfaßt in einem Siliziumsubstrat (11) in vertikaler Richtung angeordnete dotierte Gebiete (13, 16, 17) für Source-, Kanal- und Drain-Gebiet, wobei das Source-Gebiet an der Oberfläche des Substrats angeordnet ist. Mindestens Source- und Kanal-Gebiet werden seitlich durch Isolationsgebiete (14) begrenzt. Unterhalb des Drain-Gebietes (13) ist eine vergrabene Schicht (12) entsprechender Dotierung vorgesehen, auf die seitlich von Source-, Kanal- und Drain-Gebiet ein tiefreichendes Anschlußgebiet (15) reicht. Gatedielektrikum (19) und Gateelektrode (110) sind an der Oberfläche eines Grabens (18) angeordnet, der im wesentlichen senkrecht zur Oberfläche des Substrats (11) verläuft und der bis in das Drain-Gebiet (13) hineinreicht. Die Kanallänge beträgt insbesondere 50 bis 100 nm.

## Beschreibung

Die Stromergiebigkeit und damit die Schaltgeschwindigkeit eines MOS-Transistors hängt von der Kanallänge des MOS-Transistors ab. Schnelle MOS-Transistoren werden insbesondere für Logikschaltungen benötigt.

Bei diesen Anwendungen werden derzeit MOS-Transistoren verwendet, deren Source-Gebiet, Kanal-Gebiet und Drain-Gebiet an der Oberfläche eines Halbleitersubstrats lateral nebeneinander angeordnet sind. Oberhalb des Kanalgebietes ist eine Gateelektrode angeordnet.

Da in modernen Prozessen zur Herstellung von MOS-Transistoren Source- und Drain-Gebiet nach der Strukturierung der Gateelektrode hergestellt werden und da dabei die Gateelektrode Teil einer dabei verwendeten Maske ist, wird die Kanallänge des MOS-Transistors durch die Abmessung der Gateelektrode parallel zur Oberfläche des Substrats festgelegt. Die Reduktion der Kanallängen ist daher durch die minimale Ausdehnung der Gateelektrode begrenzt. Die minimal erreichbare Kanallänge hängt von der Auflösungsgrenze und der Justiergenauigkeit der verwendeten Fotolithographie ab und kann damit nicht beliebig verkleinert werden.

Der Erfindung liegt daher das Problem zugrunde, einen MOS-Transistor anzugeben, dessen Kanallänge unabhängig von der Auflösungsgrenze und Justiergenauigkeit der verwendeten Lithographie eingestellt werden kann. Weiter ist es Aufgabe der vorliegenden Erfindung, ein Herstellverfahren für einen solchen MOS-Transistor anzugeben.

Das Problem wird erfindungsgemäß gelöst durch einen Kurzkanal-MOS-Transistor nach Anspruch 1 sowie durch ein Verfahren zu dessen Herstellung nach Anspruch 5.

In dem erfindungsgemäßen Kurzkanal-MOS-Transistor sind in einem Substrat aus Silizium in vertikaler Richtung dotierte Gebiete für Source-, Kanal- und Drain-Gebiet angeordnet. Gatedielektrikum und Gateelektrode sind an der Oberfläche eines Grabens angeordnet, der im wesentlichen senkrecht zur Oberfläche des Substrats verlauft und der bis in das Drain-Gebiet hineinreicht. Das Draingebiet ist über eine vergrabene Schicht und ein seitlich von Source-, Kanal- und Drain-Gebiet angeordnetes tiefreichendes Anschlußgebiet von der Oberfläche des Substrats kontaktierbar. In dem erfindungsgemäßen Kurzkanal-MOS-Transistor ist die Kanallänge durch die Weite des Kanal-Gebietes gegeben. Das Kanal-Gebiet und das Source-Gebiet wird durch Implantation und/oder Diffusion hergestellt. Mit diesen Verfahren lassen sich Weiten des Kanalgebiets und damit Kanallängen im Bereich zwischen 50 und 100 nm leicht herstellen.

Die vertikale Anordnung von Source-, Kanal- und Drain-Gebiet in einem Substrat ist für Leistungs-MOS-Transistoren bekannt (s. z. B. D. Ueda et al, IEEE Vol. ED-34, 1987, S. 926-930). Bei den Leistungs-MOS-Transistoren wird diese Anordnung realisiert, um bei steigender Packungsdichte die Spannungsfestigkeit der Transistoren zwischen Source und Drain zu erhalten. Dieses erfolgt dadurch, daß das Kanalgebiet in der Richtung senkrecht zur Oberfläche des Substrats möglichst groß gewählt wird. Die vertikale Anordnung von Source-, Kanal- und Drain-Gebiet erfolgt hier, um eine möglichst große Kanallänge zu erhalten. Das Problem einer möglichst hohen Schaltgeschwindigkeit stellt sich bei Leistungs-MOS-Transistoren nicht.

Es liegt insbesondere im Rahmen der Erfindung, das Source-Gebiet aus einer entsprechend dotierten, an der Oberfläche des Substrats angeordneten Polysiliziumstruktur und dem im Substrat unter der Polysiliziumstruktur angeordneten dotierten Gebiet zu bilden. Die Oberfläche der Polysiliziumstruktur ist in dieser Ausführungsform mit einer Isolationsstruktur bedeckt. Dadurch werden große Überlapps der Gateelektrode über das Source-Gebiet und damit Sperrschichtkapazitäten reduziert.

Durch vollständiges Ausfüllen des Grabens mit der Gateelektrode weist der Kurzkanal-MOS-Transistor eine planare Struktur auf.

Zur Herstellung des Kurzkanal-MOS-Transistors werden zur Bildung des Kanal-Gebietes und des Source-Gebietes Prozeßschritte eingesetzt, die zur Herstellung flacher Dotierstoffgebiete geeignet sind. Insbesondere wird das Kanal-Gebiet durch Niederenergieimplantation hergestellt. Das Source-Gebiet wird z. B. durch Ausdiffusion aus einer entsprechend dotierten Schicht, die an der Oberfläche des Substrats aufgebracht wird, gebildet. Dazu ist z. B. dotiertes Borphosphorsilikatglas geeignet. Dieses wird nach der Herstellung des Source-Gebietes entfernt.

Gemäß einer anderen Ausführungsform der Erfindung wird das Source-Gebiet durch Ausdiffusion aus einer entsprechend dotierten Polysiliziumstruktur gebildet, die an der Oberfläche des Substrats verbleibt und die Teil des Source-Gebiets ist.

Zur Herstellung von Kanal-Gebiet und Source-Gebiet sind alle Prozeßschritte zur Bildung flacher Dotierstoffgebiete geeignet, die aus der Bipolartechnologie zur Herstellung flacher Basis/Emitterprofile bekannt sind.

Es liegt dabei im Rahmen der Erfindung, zur Herstellung von Kanal-Gebiet und Source-Gebiet eine epitaktische Abscheidung des Kanal-Gebietes durch CVD- oder MBE-Verfahren vorzunehmen. Die epitaktische Abscheidung erfolgt dabei undotiert oder niedrig dotiert. Anschließend wird die Schwellenspannung eingestellt durch Implantation. Das Source-Gebiet wird schließlich durch Ionenimplantation realisiert. Alternativ wird das Source-Gebiet durch Ausdiffusion aus einem entsprechend dotierten Source-Anschlußgebiet aus dotiertem Polysilizium realisiert. Dabei kann das dotierte Polysilizium sowohl durch dotierte Abscheidung als auch durch undotierte Abscheidung und anschließende Implantation hergestellt werden. Es ist vorteilhaft, das Kanal-Gebiet durch dotierte epitaktische Abscheidung mittels CVD oder MBE-Verfahren herzustellen. In diesem Fall wird bei der dotierten epitaktischen Abscheidung die Schwellenspannung eingestellt. Die Herstellung des Source-Gebietes erfolgt dann durch Ausdiffusion aus entsprechend dotiertem Polysilizium oder durch Implantation.

Weitere Ausgestaltungen der Erfindung gehen aus den übrigen Ansprüchen hervor.

Im folgenden wird die Erfindung anhand der Ausführungsbeispiele und der Figuren näher erläutert.
- Fig. 1: zeigt ein Substrat mit einer vergrabenen Schicht, Isolationsgebieten und tiefreichenden Anschlußgebieten.
- Fig. 2: zeigt das Substrat nach der Herstellung von Kanal-Gebiet und Soiurce-Gebiet.
- Fig. 3: zeigt das Substrat nach der Herstellung eines Grabens, der bis in das Drain-Gebiet hineinreicht und der mit einem Gatedielektrikum und einer Gateelektrode versehen wird.
- Fig. 4: zeigt das Substrat nach Bildung einer planarisierenden Passivierungsschicht und Öffnung und Metallisierung von Kontaktlöchern.
- Fig. 5: zeigt ein Substrat mit einer vergrabenen Schicht, tiefreichenden Anschlußgebieten, Isolationsgebieten und einem Kanalgebiet, an dessen Oberfläche eine Doppelschicht aus dotiertem Polysilizium und Siliziumoxid erzeugt wurde.
- Fig. 6: zeigt das Substrat nach einem Diffusionsschritt, der Öffnung eines Grabens, der bis in das Drain-Gebiet hineinreicht, und der Füllung des Grabens mit Gatedielektrikum und Gateelektrode.
- Fig. 7: zeigt das Substrat nach der Bildung einer planarisierenden Passivierungsschicht, in der Kontaktlocher geöffnet und mit Metallisierungen versehen sind.

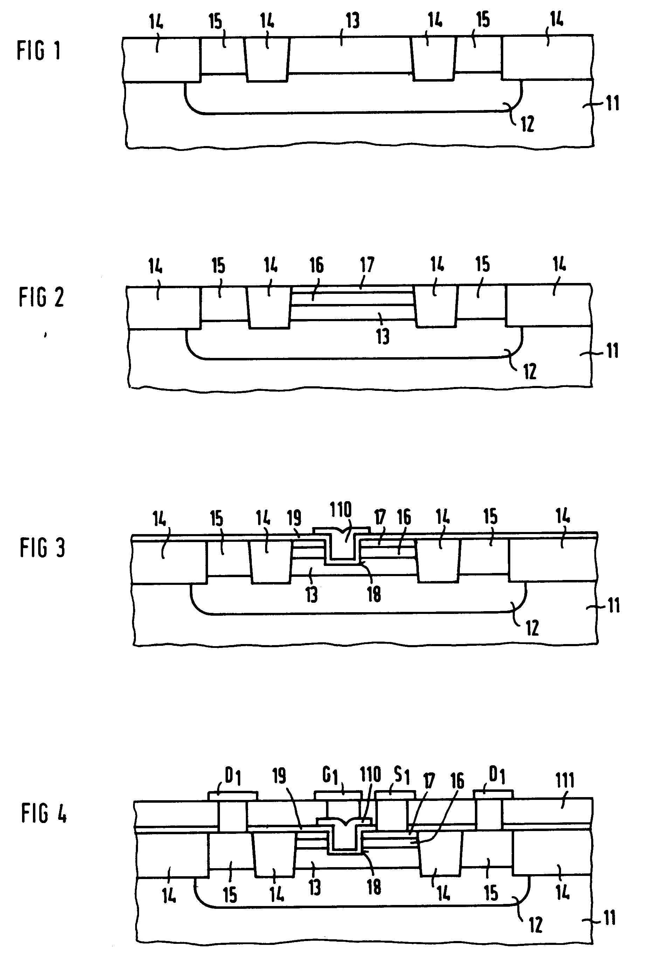

In einem Substrat 11 aus einkristallinem Silizium, das z. B. p-leitend ist, wird eine vergrabene Schicht 12, die z. B. n⁺-dotiert ist, durch Implantation oder Ausdiffusion hergestellt (s. Fig. 1).

Darauf wird ganzflächig eine n-leitende Siliziumschicht 13 in einem CVD-Verfahren, z. B. durch Epitaxie, abgeschieden.

In der Siliziumschicht 13 werden Isolationsgebiete 14 gebildet, die bis in die vergrabene Schicht 12 bzw. das Substrat 11 hineinreichen. Die Isolationsgebiete 14 umgeben aktive Transistorgebiete ringförmig. Des weiteren isolieren sie den MOS-Transistor gegen benachbarte aktive Komponenten im Substrat. Die Isolationsgebiete 14 werden z. B. durch lokale Oxidation (locos) oder durch Boxisolation gebildet.

Es wird ein Anschlußgebiet 15 zu der vergrabenen Schicht 12 hergestellt. Das Anschlußgebiet 15 wird durch Implantation oder Ausdiffusion von Arsen oder Phosphor mit einem anschließenden Temperschritt hergestellt.

Durch Implantation mit Bor wird eine p-dotierte Schicht 16 hergestellt, in der eine Dotierstoffkonzentration von etwa 10¹⁸ cm⁻³ eingestellt wird (s. Fig. 2). Die Implantation erfolgt mit einer Energie von etwa 10 keV. Dadurch ergibt sich eine Tiefe des p-dotierten Gebietes 16 von etwa 200 nm. Anschließend wird durch Implantation von z. B. Arsen ein n⁺-dotiertes Gebiet 17 oberhalb des p-dotierten Gebietes 16 hergestellt. In dem n⁺-dotierten Gebiet 17 wird eine Dotierstoffkonzentration von z. B. 10²¹ cm⁻² eingestellt. Die Implantation mit Arsen erfolgt bei einer Energie von z. B. 50 keV. Dadurch ergibt sich eine Tiefe des n⁺-dotierten Gebietes 17 von etwa 100 nm.

In dem fertigen MOS-Transistor wirkt das n⁺-dotierte Gebiet 17 als Source, das p-dotierte Gebiet 16 als Kanal-Gebiet und der unter dem p-dotierten Gebiet 16 verbliebene Teil der Siliziumschicht 13 als Drain. Die Kanallänge wird in dem MOS-Transistor durch die Weite des p-dotierten Gebietes 16 eingestellt.

Senkrecht zur Oberfläche des Substrats 11 wird ein Graben 18 geätzt. Der Graben 18 wird z. B. durch eine RIE-Ätzung mit der Chemie HBr/NF₃/He/O₂ geätzt. Der Graben 18 durchtrennt das p-dotierte Gebiet 16 und das n⁺-dotierte Gebiet 17 und reicht bis in den darunterliegenden Teil der Siliziumschicht 13 hinein.

Die Oberfläche des Grabens wird mit einem Gatedielektrikum 19 versehen (s. Fig. 3). Das Gatedielektrikum 19 wird z. B. aus SiO₂ gebildet. Es wird entweder z. B. in einem CVD-Verfahren abgeschieden oder thermisch aufgewachsen. Durch Abscheidung in einem CVD-Verfahren ist zwar die thermische Belastung geringer, da ein niedriges Dt-Produkt auftritt, es hat jedoch hohe Interface-Dichten zur Folge. Thermisch aufgewachsenes SiO₂ vermeidet hohe Interface-Dichten, führt jedoch zu einem höheren Dt-Produkt.

Es wird eine Gateelektrode 110 hergestellt, die den Graben 18 vollständig ausfüllt. Die Gateelektrode 110 wird z. B. durch ganzflächiges Aufbringen einer Polysiliziumschicht, Dotierung der Polysiliziumschicht und Strukturierung der Polysiliziumschicht gebildet. Die Gateelektrode wird z. B. n⁺-dotiert. Die Dotierung erfolgt z. B. durch Implantation von Arsen, Belegung oder in situ.

Es wird eine planarisierende, dielektrische Schicht 111 ganzflächig abgeschieden. Als dielektrische Schicht 111 wird z. B. BPSG, TEOS-SiO₂, SOG oder LTO verwendet. In der dielektrischen Schicht 111 werden Kontaktlöcher zu den Anschlußgebieten 15, der Gateelektrode 110 und dem n⁺-dotierten Gebiet 17 geöffnet. Die Kontaktlöcher werden mit Metallisierungen versehen. Dazu werden die Kontaktlöcher z. B. mit Wolfram aufgefüllt und an der Oberfläche mit Aluminium kontaktiert. Dadurch werden Kontakte zum Drain-Gebiet D₁, zum Source-Gebiet S₁ und zur Gateelektrode G₁ realisiert.

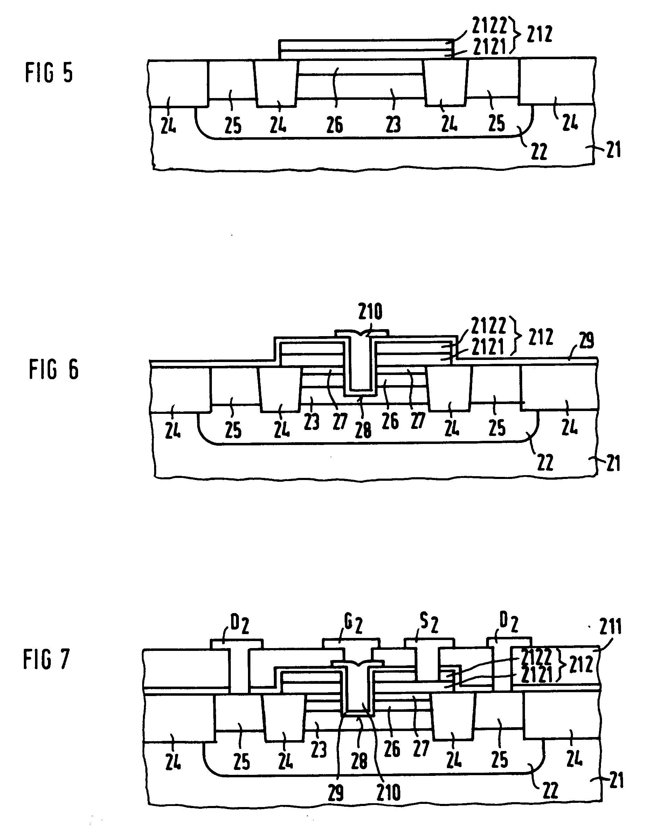

In einer zweiten Ausführungsform der Erfindung wird in einem z. B. p-leitenden Substrat 21 eine z. B. n⁺-dotierte vergrabene Schicht 22 durch Implantation oder Ausdiffusion hergestellt (s. Fig. 5). Darauf wird ganzflächig z. B. durch Epitaxie eine n-leitende Siliziumschicht 23 aufgebracht. In der Siliziumschicht 23 werden Isolationsgebiete 24 z. B. durch lokale Oxidation oder Boxisolation erzeugt.

Durch Implantation oder Ausdiffusion von Arsen oder Phosphor werden tiefreichende Anschlußgebiete 25 gebildet, die bis auf die vergrabene Schicht 22 reichen. Bis hierher ist das Herstellverfahren gemäß der zweiten Ausführungsform mit dem der ersten Ausführungsform identisch.

Durch Implantation mit Bor mit einer Energie von z. B. 10 keV und einer Dosis von z. B. 5 x 10¹³ cm⁻² wird ein p-dotiertes Gebiet 26 erzeugt.

Es wird ganzflächig eine Doppelschicht 212 bestehend aus n⁺-dotiertem Polysilizium 2121 und aus CVD-SiO₂ 2122 abgeschieden. Die Doppelschicht 212 wird in einem Trockenätzverfahren so strukturiert, daß eine Polysiliziumstruktur entsteht, die das p-dotierte Gebiet 26 vollständig überdeckt (s. Fig. 5).

Oberhalb des p-dotierten Gebietes 26 wird durch Ausdiffusion aus dem n⁺-dotierten Polysilizium 2121 ein n⁺-dotiertes Gebiet 27 erzeugt. In dem fertigen MOS-Transistor wirken das n⁺-dotierte Gebiet 27 und das n⁺-dotierte Polysilizium 2121 als Source-Gebiet, das p-dotierte Gebiet 26 als Kanal-Gebiet und der unterhalb des p-dotierten Gebietes 26 angeordnete Teil der Siliziumschicht 23 als Drain-Gebiet.

In einem Trockenätzprozeß, z. B. einer RIE-Ätzung mit der Chemie HBr/NF₃/He/O₂, wird ein Graben 28 geätzt, der im wesentlichen senkrecht zur Oberfläche des Substrats 21 verläuft. Der Graben 28 durchtrennt die Doppelschicht 212, das n⁺-dotierte Gebiet 27 und das p-dotierte Gebiet 26. Der Graben 28 reicht bis in die Siliziumschicht 23 hinein (s. Fig. 6).

Wie in dem ersten Ausführungsbeispiel wird ganzflächig ein Gatedielektrikum 29 aus z. B. SiO₂ erzeugt. Das Gatedielektrikum 29 bedeckt die Oberfläche des Grabens 28 vollständig. Schließlich wird der Graben 28 mit einer Gateelektrode 210 aufgefüllt. Die Gateelektrode 210 besteht z. B. n⁺-dotiertem Polysilizium und wird wie anhand von Fig. 3 erläutert hergestellt.

Nach Abscheiden einer planarisierenden, dielektrischen Schicht 211 aus z. B. BPSG, TEOS-SiO₂, SOG oder LTO wird der MOS-Transistor durch Öffnen von Kontaktlöchern zu den Anschlußgebieten 25, der Gateelektrode 210 und dem n⁺-dotierten Polysilizium 2121 und Auffüllung dieser Kontaktlöcher mit Metallisierungen für einen Drain-Kontakt D₂, einen Gate-Kontakt G₂ und einen Source-Kontakt S₂ fertiggestellt.

Die Ausführungsbeispiele wurden auf der Basis eines n-leitenden MOS-Typs beschrieben. Die Erfindung ist analog anwendbar zur Herstellung eines p-leitenden MOS-Typs. In diesem Fall werden die Ladungstypen aller Dotierstoffe umgekehrt.

Das erfindungsgemäße Herstellverfahren ist weitgehend mit Bipolarprozessen kompatibel, so daß das Herstellverfahren besonders gut geeignet ist für die Integration von MOS-Transistoren in Bipolarprozessen.

## Patentansprüche

1. Kurzkanal-MOS-Transistor,
- bei dem in einem Siliziumsubstrat (11, 21) in vertikaler Richtung dotierte Gebiet für Source (17, 27), Kanal- (16, 26) und Drain-Gebiet (13, 23) angeordnet sind, wobei das Source-Gebiet (17, 27) an der Oberfläche des Substrats (11, 21) angeordnet ist und mindestens Source-Gebiet und Kanal-Gebiet seitlich durch Isolationsgebiete (14, 24) begrenzt werden,
- bei dem unterhalb des Drain-Gebietes (13, 23) eine vergrabene Schicht (12, 22) entsprechender Dotierung vorgesehen ist, auf die seitlich von Source-, Kanal- und Drain-Gebiet ein tiefreichendes Anschlußgebiet (15, 25) reicht,
- bei dem Gatedielektrikum (19, 29) und Gate-Elektrode (110, 210 an der Oberfläche eines Grabens (18, 28) angeordnet sind, der im wesentlichen senkrecht zur Oberfläche des Substrats (11, 21) verläuft und der bis in das Drain-Gebiet (13, 23) hineinreicht.

2. Kurzkanal-MOS-Transistor nach Anspruch 1,
bei dem die Weite des Kanal-Gebietes (16, 26) und damit die Kanallänge im Bereich zwischen unter 50 nm und 200 nm liegt.

3. Kurzkanal-MOS-Transistor nach Anspruch 1 oder 2,
bei dem das Source-Gebiet (27) aus einer entsprechend dotierten, an der Oberfläche des Substrats (21) angeordneten Polysiliziumstruktur (2121) und dem im Substrat (21) unter der Polysiliziumstruktur (2121) angeordneten dotierten Gebiet (27) gebildet wird,
bei dem die Oberfläche der Polysiliziumstruktur (2121) mit einer Isolationsstruktur (2122) bedeckt ist.

4. Kurzkanal-MOS-Transistor nach einem der Ansprüche 1 bis 3,
bei dem der Graben (18, 28) durch die Gateelektrode (110, 210) vollständig ausgefüllt ist.

5. Verfahren zur Herstellung eines Kurzkanal-MOS-Transistors,
- bei dem in einem Substrat (11, 21) aus Silizium in vertikaler Richtung dotierte Gebiete für Source- (17, 27), Kanal- (16, 26) und Drain-Gebiet (13, 23) erzeugt werden, wobei das Source-Gebiet (17, 27) an der Oberfläche des Substrats (11, 21) angeordnet ist,
- bei dem Isolationsgebiete (14, 24) erzeugt werden, die mindestens Source- und Kanal-Gebiet seitlich begrenzen,
- bei dem unterhalb des Drain-Gebietes eine vergrabene Schicht (12, 22) entsprechender Dotierung erzeugt wird,
- bei dem seitlich von Source-, Kanal- und Drain-Gebiet ein tiefreichendes Anschlußgebiet (15, 25) gebildet wird, daß durch die Isolationsgebiete gegen Source- und Kanal-Gebiet isoliert ist und das auf die vergrabene Schicht (12, 22) reicht,
- bei dem ein im wesentlichen senkrecht zur Oberfläche des Substrats (11, 21) verlaufender Graben (18, 28) erzeugt wird, der bis in das Drain-Gebiet (13, 23) hineinreicht,
- bei dem an der Oberfläche des Grabens (18, 28) ein Gatedielektrikum (19, 29) und an der Oberfläche des Gatedielektrikums (19, 29) eine Gateelektrode (110, 210) gebildet wird.

6. Verfahren nach Anspruch 5,
bei dem das Kanal-Gebiet mit einer Weite im Bereich zwischen unter 50 nm und 200 nm hergestellt wird.

7. Verfahren nach Anspruch 5 oder 6,
bei dem das Kanal-Gebiet durch Implantation von Bor mit einer Energie zwischen 5 keV und 25 keV und einem anschließenden Kurzzeitausheilschritt bei einer Temperatur zwischen 900 und 1000 °C wahrend 5 bis 20 Sekunden hergestellt wird.

8. Verfahren nach einem der Ansprüche 5 bis 7,
- bei dem zur Bildung des Source-Gebiets auf die Oberfläche des Substrats (21) eine Doppelschicht (212) aus entsprechend dotiertem Polysilizium und SiO₂ abgeschieden und strukturiert wird,
- bei dem durch Ausdiffusion aus der Polysiliziumstruktur (2121) an der Oberfläche des Substrats (21) ein dotiertes Gebiet erzeugt wird, das gemeinsam mit der Polysiliziumstruktur als Source-Gebiet wirkt.

9. Verfahren nach einem der Ansprüche 5 bis 8,
bei dem die Source- und Kanal-Gebiet seitlich begrenzenden Isolationsgebiete (14, 24) in einem Locos-Prozeß oder durch Erzeugen eines Grabens, der mit dielektrischem Material aufgefüllt wird, hergestellt werden.

10. Verfahren nach einem der Ansprüche 5 bis 9,
bei dem in dem Substrat zusätzlich mindestens ein Bipolartransistor hergestellt wird.
